(19) Europäisches Patentamt
European Patent Office
Office européen des brevets

(11) **EP 4 348 230 B1**

(12) **FASCICULE DE BREVET EUROPEEN**

(45) Date de publication et mention
de la délivrance du brevet:
**18.03.2026 Bulletin 2026/12**

(21) Numéro de dépôt: **22731245.1**

(22) Date de dépôt: **02.06.2022**

(51) Classification Internationale des Brevets (IPC):
**G01N 23/201** *(2018.01)* **H05H 3/02** *(2006.01)*
**G01N 23/207** *(2018.01)* **H01L 21/302** *(2006.01)*
**H01J 37/32** *(2006.01)* **H01J 37/34** *(2006.01)*

(52) Classification Coopérative des Brevets (CPC):
**G01N 23/201; G01N 23/207; H01J 37/32816;
H01J 37/32917; H01J 37/32935; H01J 37/3405;**
G01N 2223/105; G01N 2223/316

(86) Numéro de dépôt international:
**PCT/EP2022/065007**

(87) Numéro de publication internationale:
**WO 2022/253939 (08.12.2022 Gazette 2022/49)**

(54) **DISPOSITIF D'ANALYSE DE SURFACE PAR DIFFRACTION D'ATOMES RAPIDES DANS UN ENVIRONNEMENT HAUTE PRESSION**

VORRICHTUNG ZUR OBERFLÄCHENANALYSE DURCH BEUGUNG SCHNELLER ATOME IN EINER HOCHDRUCKUMGEBUNG

DEVICE FOR SURFACE ANALYSIS BY FAST ATOM DIFFRACTION IN A HIGH-PRESSURE ENVIRONMENT

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **04.06.2021 EP 21305760**

(43) Date de publication de la demande:
**10.04.2024 Bulletin 2024/15**

(73) Titulaires:
• **Centre National de la Recherche Scientifique
75016 Paris (FR)**
• **Université Paris-Saclay
91190 Gif-sur-Yvette (FR)**
• **CY Cergy Paris Université
95011 Cergy-Pontoise Cedex (FR)**

(72) Inventeurs:
• **KHEMLICHE, Hocine
91170 VIRY CHATILLON (FR)**
• **MOMENI, Anouchah
92100 BOULOGNE BILLANCOURT (FR)**

• **MINEA, Tiberiu
75016 PARIS (FR)**
• **STAICU - CASAGRANDE, Elena-Magdalena
91470 LIMOURS (FR)**
• **LUPONE, Sylvain
91190 SAINT AUBIN (FR)**

(74) Mandataire: **IPAZ
Bâtiment Platon
Parc Les Algorithmes
91190 Saint-Aubin (FR)**

(56) Documents cités:
**FR-A1- 2 903 494     US-A- 5 115 130**

• **HOFSTADLER S. A. ET AL: "Concentric tube
vacuum chamber for high magnetic field, high-
pressure ionization in a fourier transform ion
cyclotron resonance mass spectrometer",**
JOURNAL OF THE AMERICAN SOCIETY FOR
MASS SPECTROMETRY, vol. 4, no. 2, 1 February
1993 (1993-02-01), US, pages 168 - 176,
XP055855718, ISSN: 1044-0305, DOI: 10.1016/
1044-0305(93)85073-7

## Description

### Domaine technique :

La présente invention concerne un dispositif de caractérisation de surfaces. Plus particulièrement le dispositif de l'invention permet de déterminer la structure cristallographique de surfaces et le suivi de croissance de couches minces.

### Technique antérieure :

La technique RHEED (pour Reflection High Energy Electron Diffraction en anglais) est l'outil le plus utilisé pour réaliser la caractérisation *in situ* de couches cristallines. Cette technique présente l'avantage d'être compatible avec la croissance par épitaxie par faisceaux moléculaires (MBE pour Molecular Beam Epitaxy en anglais) qui est une des méthodes de croissance de couches cristallines la plus répandue. La méthode RHEED permet une caractérisation complète de la structure cristallographique d'une surface. Elle permet aussi le suivi en temps réel de la croissance couche par couche d'un cristal par MBE.

Il est connu du document FR2903494 de réaliser la caractérisation d'une surface cristallographique à l'aide d'un dispositif exploitant la diffraction d'atomes ou de molécules neutres en incidence rasante. Cette technique, appelée GIFAD (pour Grazing Incidence Fast Atom Diffraction) présente de nombreuses similarités avec l'outil RHEED. En plus de permettre l'obtention des mêmes informations sur la structure de la couche cristalline que la méthode RHEED, la méthode GIFAD présente plusieurs avantages liés à l'utilisation de particules neutres :

- une sensibilité exclusive à la dernière couche de la surface grâce à une profondeur de pénétration des atomes ou molécules neutres fortement réduite comparativement à celle des électrons,

- une mesure portant sur le profil de densité électronique plutôt que la position des noyaux,

- une insensibilité aux champs électromagnétiques, et

- une capacité à opérer sans dommage sur des matériaux fragiles.

La figure 1 illustre schématiquement le dispositif du document FR2903494. Ce dispositif est une machine pour épitaxie moléculaire 1000 équipée d'un dispositif de caractérisation de surface par GIFAD. La machine 1000 est constituée d'une enceinte 1100 reliée à un système de pompage 5 qui produit un ultravide dans l'enceinte. Dans l'enceinte 1100 débouchent des cellules d'effusion 1200 qui produisent des faisceaux moléculaires. En face de ces cellules est situé un support 1300 pour un substrat 3' sur lequel doit être déposée par épitaxie la surface 3. Un moyen de génération 1 d'un faisceau atomique ou moléculaire à haute énergie est adapté pour émettre dans l'enceinte 1100 par une entrée 1400. Un moyen de détection 4 sensible en position constitué par exemple par une galette de microcanaux couplée à un écran fluorescent observé par une caméra est agencé dans la paroi de l'enceinte 1100.

Le faisceau 2 est dirigé vers une surface 3 à caractériser selon un angle d'incidence $\theta_{inc}$, éventuellement variable, non supérieur à 10° environ (incidence rasante). Ici et dans la suite, les angles sont mesurés par rapport au plan de la surface cible 3. Comme dans la technique RHEED, l'espace directement au-dessus de la surface 3 reste libre, ce qui permet une croissance par épitaxie par faisceaux moléculaires simultanément à la mesure.

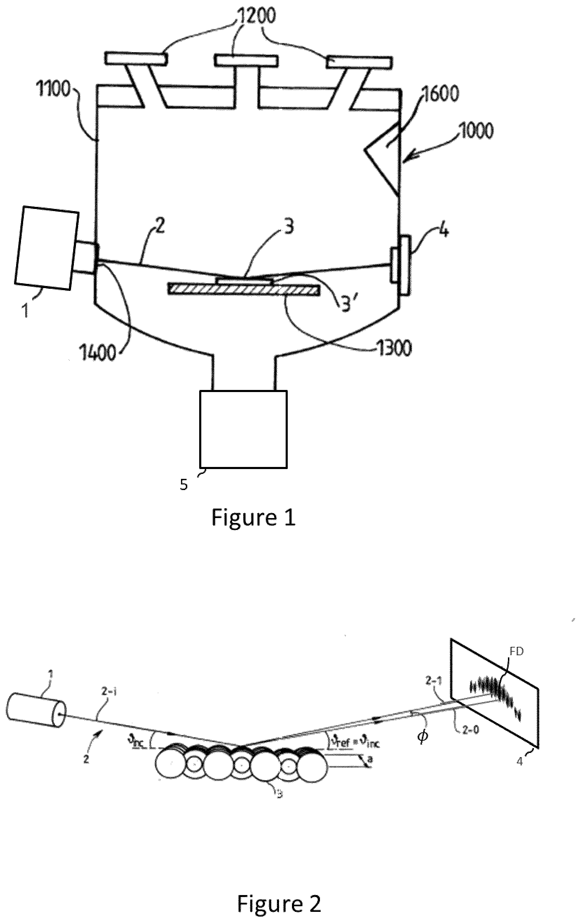

Les atomes ou molécules neutres du faisceau 2 sont réfléchis par la surface 3, avec un angle de réflexion $\theta_{ref} \approx \theta_{inc}$ en subissant une diffraction dans une direction azimutale, c'est à dire parallèle à la surface 3 à cause de la structure de la surface 3. Sur la figure 2, le faisceau atomique ou moléculaire incident est indiqué par la référence 2-i, le faisceau spéculaire par 2-0 (car il s'agit de l' « ordre zéro » de diffraction) et le premier faisceau non spéculaire par 2-1 (premier ordre de diffraction). Comme en RHEED l'angle $\Phi$, formé par les projections sur un plan parallèle à celui de la surface 3 du faisceau diffracté au premier ordre 2-1 et du faisceau diffracté à l'ordre zéro 2-0, est indirectement lié au paramètre de maille a de la surface cristalline 3 dans la direction transversale par rapport au mouvement des atomes ou molécules incidents par la relation suivante : *d. tanΦ = nλ,* avec n entier et avec d la période vue par le faisceau, qui est liée à a par une simple relation de proportionnalité qui dépend de la structure cristalline et de la direction d'observation. Ainsi, on déduit l'angle $\phi = \arctan\left(\frac{\lambda}{d}\right)$ pour le premier ordre de diffraction, où $\lambda$ est la longueur d'onde de de Broglie des particules incidentes. La figure de diffraction FD est alors détectée par le moyen de détection 4.

La méthode GIFAD présentée dans le document FR2903494 a apporté la preuve de son efficacité pour l'étude structurale des surfaces et le suivi de croissance de couches minces, notamment sur les procédés fonctionnant dans une enceinte à très basse pression comme la MBE. La méthode GIFAD de l'art antérieur fonctionne à des pressions allant de $10^{-10}$ mbar à $10^{-5}$ mbar dans l'enceinte 1100, la limitation à cette gamme de pression provenant de deux raisons :

- du type de détecteur utilisé (galette de microcanaux couplé à un écran phosphore) pour lequel le signal utile devient difficilement exploitable lorsque la pression dépasse $10^{-5}$ mbar, et

- de la nécessité de préserver la cohérence du faisceau d'atomes lors de son parcours dans l'enceinte en limitant la probabilité de collision avec le gaz résiduel, à défaut de quoi le contraste des franges de la figure de diffraction est diminué, cette dernière pouvant être alors inexploitable.

Cependant, certains procédés de croissance de couches minces (comme le dépôt plasma magnétron, le dépôt chimique en phase vapeur, ou l'ablation par laser pulsé), de modification de surfaces (traitement par plasma ou modifications chimiques) ou de catalyse fonctionnent dans un environnement à haute pression (jusqu'à $10^{-2}$ *mbar* voir au delà) et ne sont donc pas compatibles avec le dispositif de l'art antérieur.

L'invention vise à pallier certaines limitations de l'art antérieur. A cet effet, un objet de l'invention est un dispositif pour la caractérisation d'une surface d'un échantillon par GIFAD dans lequel est mise en œuvre un pompage différentiel d'une enceinte de détection dans laquelle est réalisée la détection de la figure de diffraction. Ainsi, une pression inférieure à $10^{-5}$ *mbar*, compatible avec une détection par microcanaux, est obtenue au sein de l'enceinte de détection alors que la chambre comprenant l'échantillon peut présenter une pression jusqu'à $10^{-2}$ *mbar* compatible avec les procédés de croissance de couches minces ou de modification de surfaces fonctionnant à haute pression.

### Résumé de l'invention :

A cet effet, un objet de l'invention est un dispositif pour la caractérisation d'une surface d'un échantillon comportant :

- une chambre comprenant un support pour ledit échantillon, ladite chambre étant reliée à une pompe dite primaire adaptée pour maintenir une pression inférieure à $10^{-2}$ *mbar* au sein de ladite chambre ;

- une source de génération d'un faisceau incident d'atomes ou molécules neutres ayant une énergie comprise entre 50 eV et 5 keV, avec une divergence inférieure ou égale à 0,05°, ladite source étant agencée pour diriger ledit faisceau incident au sein de ladite chambre par une entrée et vers ladite surface à caractériser avec un angle d'incidence inférieur ou égal à 10° par rapport au plan de ladite surface, les atomes ou molécules neutres dudit faisceau incident, diffusés vers l'avant par ladite surface formant un faisceau diffracté ; et

- une enceinte de détection reliée à ladite chambre et reliée à une pompe dite UHVP comprenant :

  - un ensemble de tubes concentriques chaque tube présentant une extrémité dite d'entrée avec une ouverture, ledit ensemble comprenant un tube de plus petit rayon, de longueur L ;

  - un détecteur sensible en position et adapté pour détecter une figure de diffraction des atomes ou molécules neutres dudit faisceau diffracté ;

  - ladite longueur L et lesdites ouvertures étant adaptées pour transporter ledit faisceau diffracté jusqu'au détecteur sans perdre d'information sur ladite surface, lesdites ouvertures et ladite pompe UHVP étant adaptées pour maintenir une pression inférieure à $10^{-5}$ *mbar* au sein de l'enceinte de détection

Avantageusement, l'ouverture de chaque tube presente un diamètre différent des autres et décroissant en fonction du rayon des tubes.

Avantageusement, une ouverture de plus petit diamètre présente un diamètre inférieur ou égal à 5 mm.

Avantageusement, une distance dite haute pression entre ladite entrée et une extrémité d'entrée des tubes est inférieure à une longueur de décohérence du faisceau incident et du faisceau diffracté.

Avantageusement, chaque tube présente une extrémité dite de sortie avec une collerette s'étendant dans une direction essentiellement perpendiculaire aux tubes de manière à guider un flux gazeux dans cette direction en sortie de chaque tube, un port de couplage de ladite pompe UHVP étant disposé dans ladite enceinte de détection en regard d'un espace formé par lesdites collerettes.

Avantageusement, ledit détecteur comprend une galette de microcanaux, couplée à un écran fluorescent observé par une caméra.

Avantageusement, ladite source est adaptée pour que ledit angle d'incidence puisse être varié, ledit dispositif comprenant également un étage de translation et/ou de rotation dudit ensemble de tubes de manière à ajuster une position desdites ouvertures en fonction dudit angle d'incidence.

Un autre objet de l'invention est un système pour dépôt par plasma magnétron comprenant un dispositif selon l'invention agencé pour caractériser ladite surface de l'échantillon en cours de dépôt.

### Brève description des figures :

D'autres caractéristiques, détails et avantages de l'invention ressortiront à la lecture de la description faite en référence aux dessins annexés donnés à titre d'exemple et qui représentent, respectivement :

Figure 1, une vue schématique d'un dispositif pour la caractérisation d'une surface d'un échantillon par la technique GIFAD selon l'art antérieur,

Figure 2, une illustration de la diffraction du faisceau atomique ou moléculaire incident par la surface d'un échantillon lors de la technique GIFAD selon l'art antérieur,

Figure 3, une vue schématique d'un dispositif selon l'invention pour la caractérisation d'une surface d'un échantillon par la technique GIFAD,

Figure 4, une vue schématique agrandie de l'enceinte ZDU du dispositif de l'invention,

Figure 5, une vue schématique d'un système pour dépôt par plasma magnétron comprenant un dispositif selon l'invention pour caractériser la surface de l'échantillon par la technique GIFAD au cours de son dépôt.

Dans les figures, sauf contre-indication, les éléments ne sont pas à l'échelle.

## Description détaillée :

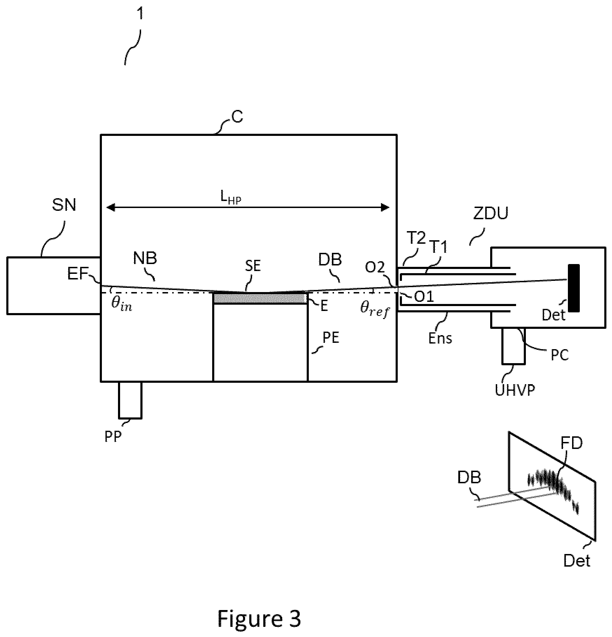

La figure 3 illustre un dispositif 1 selon l'invention, pour la caractérisation d'une surface SE d'un échantillon E par la technique GIFAD. Le dispositif comprend une chambre C comprenant un support PE pour l'échantillon E.

Le dispositif 1 comprend une source SN de génération d'un faisceau incident NB d'atomes ou molécules neutres ayant une énergie comprise entre 50 eV et 5 keV, avec une divergence inférieure ou égale à 0,05°. Cette source est connue de l'art antérieur et est décrite plus en détail dans le document FR2903494. Aussi, par concision, sa description ne sera pas reprise ici. On note simplement qu'elle comprend typiquement trois étages : un générateur d'un faisceau d'ions atomiques ou moléculaires, un neutraliseur et un collimateur. La source d'ions comprend un ensemble d'électrodes permettant d'accélérer les ions à l'énergie souhaitée par application d'un champ électrostatique, ainsi que des optiques électrostatiques de focalisation. La charge électrique des ions permet de les accélérer, sélectionner et, si besoin, générer un faisceau pulsé beaucoup plus facilement que des particules neutres. Le faisceau d'ions est alors neutralisé par échange de charge dans une cellule remplie de gaz. Le faisceau atomique ou moléculaire sortant du neutraliseur présente en général une divergence trop élevée pour que l'observation de la diffraction par la surface cible SE soit possible, et doit donc être collimaté à l'aide du collimateur, typiquement constitué d'un couple de diaphragmes.

Dans le dispositif de l'invention, la source SN est agencée pour diriger le faisceau incident NB au sein de la chambre C par une entrée EF. Ce faisceau NB est dirigé vers la surface SE à caractériser en condition d'incidence rasante, c'est-à-dire avec un angle d'incidence $\theta_{in}$ inférieur ou égal à 10° par rapport au plan de la surface. Cette condition d'incidence rasante permet d'assurer une pénétration minimale des atomes ou molécules neutres au sein de l'échantillon et donc une sensibilité à la dernière couche de l'échantillon. Par ailleurs, un angle d'incidence trop élevé dégrade sensiblement le signal de diffraction. Comme expliqué plus haut, les atomes ou molécules neutres du faisceau incident NB sont diffusés vers l'avant par la surface SE, avec un angle de réflexion $\theta_{ref} \approx \theta_{inc}$ en subissant une diffraction dans une direction azimutale à cause de la structure cristallographique de la surface. Les atomes ou molécules neutres du faisceau incident NB diffusés vers l'avant forment ainsi un faisceau diffracté DB transportant l'information spatiale caractéristique de la surface SE sous la forme d'une figure de diffraction FD en champ lointain. La figure 3 comprend une illustration d'une vue en perspective du détecteur Det et de la figure de diffraction FD.

A l'inverse du dispositif de caractérisation par la technique GIFAD de l'art antérieur dans lequel la détection était réalisée dans la chambre pompée à une pression inférieure à $10^{-5}$ *mbar*, le dispositif 1 de l'invention met en œuvre un pompage différentiel d'une enceinte de détection ZDU dans laquelle est réalisée la détection de la figure de diffraction, séparée de la chambre C. Pour rappel, on appelle pompage différentiel, la technique consistant a juxtaposer plusieurs volumes distincts entre lesquels est maintenu une différence de pression élevée, les volumes étant séparés par une ouverture de petite dimension et étant pompés par une pompe respective. Concrétement, dans l'invention, la chambre C et l'enceinte ZDU sont reliées par plusieurs volumes séparés, les volumes étant pompés par une pompe dite UHVP (voir plus loin). Ainsi, une pression inférieure à $10^{-5}$ *mbar*, compatible avec une détection par galette de microcanaux, est obtenue au sein de l'enceinte de détection ZDU alors que la chambre C comprenant l'échantillon E peut présenter une pression allant jusqu'à $10^{-2}$ *mbar* (ci après « haute pression ») compatible avec les procédés de croissance de couches minces ou de modification de surfaces fonctionnant à haute pression.

A cet effet, la chambre C est reliée à une pompe dite primaire PP par un port de couplage (non représenté), la pompe PP étant adaptée pour maintenir une pression inférieure à $10^{-2}$ *mbar* au sein de la chambre C. De manière préférentielle, la chambre C est pompée par la pompe primaire PP et une pompe turbomoléculaire additionnelle. Cette configuration est justifiée par la nécessité, hors injection de gaz, de maintenir l'ultravide (pression inférieure à $10^{-9}$ *mbar.*) afin de préserver la qualité des échantillons, la technique GIFAD étant extrêmement sensible à la contamination de surface.

Pour réaliser le pompage différentiel, l'enceinte de détection ZDU est reliée à la chambre C, et est reliée à la pompe UHVP par un port de couplage PC. Les pompes PP et UHVP sont typiquement des pompes turbomoléculaires. L'enceinte ZDU comprend un ensemble de tubes concentriques Ens, chaque tube T1, T2 présentant une extrémité dite d'entrée avec une ouverture O1, O2 respective placée à proximité de l'échantillon E. L'ensemble de tubes permet de définir des volumes juxtaposés séparant la chambre et l'environnement entourant le détecteur Det par des ouvertures de faible diamètre afin de réaliser le pompage différentiel. Le diamètre des

**EP 4 348 230 B1**

ouvertures O1, O2 et la pompe UHVP sont adaptées pour maintenir une pression inférieure à $10^{-5}$ *mbar* au sein de l'enceinte de détection ZDU.

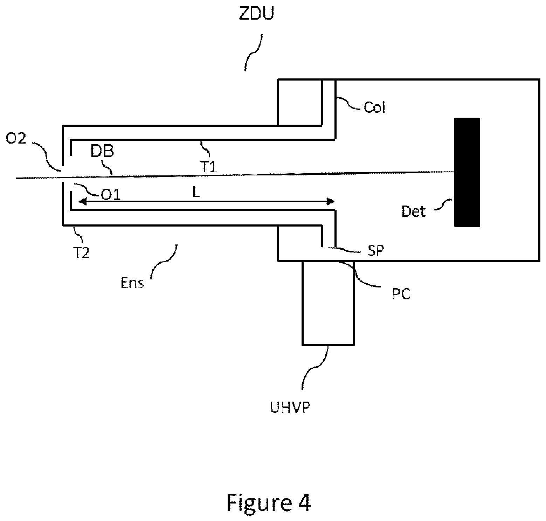

La figure 4 présente une illustration schématique de l'enceinte ZDU agrandie par rapport à la figure 3.

Afin de réaliser la détection, l'enceinte ZDU comprend le détecteur Det sensible en position et adapté pour détecter la figure de diffraction FD des atomes ou molécules neutres du faisceau diffracté FD. Par exemple, le détecteur est constitué par une galette de microcanaux couplée à un écran fluorescent observé par une caméra.

Ainsi, le pompage différentiel permet d'assurer un vide inférieur à $10^{-5}$ *mbar* dans l'enceinte ZDU garantissant un rapport signal sur bruit de la figure de diffraction sur le détecteur suffisant pour déterminer la structure de la surface, tout en ayant une pression haute (jusqu'à $10^{-2}$ *mbar*) dans la chambre C. L'invention apporte donc une solution viable à l'absence d'outil capable de suivre la croissance dans les bâtis de dépôt par plasma magnétron, technique fonctionnant à haute pression et largement utilisées dans la recherche et l'industrie et pour laquelle le RHEED est inutilisable compte tenu de l'intensité des champs électromagnétiques présent dans la chambre lors du dépôt.

Il est primordial que le trajet du faisceau diffracté entre l'échantillon et le détecteur Det se fasse sans perte d'information, c'est-à-dire sans qu'une partie de la figure de diffraction FD, pertinentes pour la caractérisation de la surface SE, soit coupée par le trajet dans l'ensemble de tubes Ens. Dans le dispositif de l'invention, le faisceau diffracté est transporté dans le tube de plus petit rayon T1, de longueur L. Aussi, la condition précitée revient à dire que la longueur L et les ouvertures O1, O2 sont adaptées pour transporter le faisceau diffracté jusqu'au détecteur Det sans perdre d'information -. Pour cela, les ouvertures placées sur les extrémités des tubes sont de diamètres progressivement plus grands au cours du trajet du faisceau diffracté DB et décroissant en fonction d'un rayon des tubes. C'est-à-dire que le tube T2 de plus grand rayon présente une ouverture O2 de plus petit diamètre et placée plus proche de l'échantillon que l'ouverture O1 du tube T1 de plus petit rayon. En effet, le faisceau diffracté DB diverge à partir de l'échantillon et les ouvertures doivent s'adapter à cette divergence. A titre d'exemple non limitatif, afin de ne pas tronquer le signal de diffraction pertinent tout en permettant un pompage différentiel atteignant une pression inférieure à $10^{-5}$ *mbar* dans l'enceinte de détection, l'ouverture O2 de plus petit diamètre présente typiquement un diamètre inférieur ou égal à 5 mm lorsqu'une distance entre l'échantillon et l'ouverture fait typiquement 5 cm.

De manière préférentielle, les ouvertures O1, O2 sont de diamètre suffisamment grand pour que la figure de diffraction détectée comprenne l'ensemble de l'intensité diffusée par la surface mais aussi une partie du faisceau direct (non diffracté par la surface). Ce dernier sert de référence angulaire et est avantageux pour une bonne interprétation des diagrammes de diffraction.

Dans le dispositif de l'invention, la probabilité de collision des atomes ou molécule des faisceaux DB et NB avec le gaz résiduel dans la chambre C est plus élevée que pour le dispositif GIFAD de l'art antérieur, compte tenu de la pression plus élevée dans la chambre C. Ces collisions entrainent un échange de moment cinétique et/ou d'énergie qui peut détruire la cohérence du faisceau d'atomes ou de molécules, réduisant ainsi le contraste des franges de la figure de diffraction. Afin d'obtenir une figure de diffraction FD sur le détecteur Det exploitable, dans l'invention, une distance dite haute pression $L_{HP}$ entre l'entrée EF et l'ouverture O2 est inférieure à une longueur de décohérence du faisceau incident. Il est entendu que cette longueur de décohérence dépend de l'énergie des atomes ou molécule des faisceaux DB et NB et de la pression dans la chambre C. A titre d'exemple, par des simulations, les inventeurs ont calculé qu'une distance haute pression $L_{HP}$ inférieure à 10 cm pour une pression d'environ $10^{-2}$ *mbar* au sein de la chambre C pour une énergie d'environ 1keV permettait de garantir la conservation partielle du caractère quantique du faisceau d'atomes ou de molécules et l'obtention d'une figure de diffraction exploitable. On note que cette distance est largement suffisante pour permettre une intégration d'un système de traitement de surface (dépôt ou gravure) au sein de la chambre C.

Dans le dispositif des figures 3 et 4, à titre d'exemple non limitatif, seulement deux tubes sont représentés mais il est entendu que l'invention peut être mise en œuvre avec plus de deux tubes. L'utilisation de plus de deux tubes permet de maintenir plus facilement une différence de pression importante entre la chambre C et l'enceinte ZDU tout en transportant le faisceau DB sans perte d'information sur la surface SE, portée par la figure de diffraction FD.

Dans le dispositif de la figure 4, selon un mode de réalisation chaque tube présente une extrémité dite de sortie avec une collerette Col s'étendant dans une direction essentiellement perpendiculaire aux tubes de manière à guider un flux gazeux, pompé par la pompe UHVP, dans cette direction en sortie de chaque tube. En outre, le port de couplage PC de la pompe UHVP est disposé dans l'enceinte de détection en regard d'un espace SP formé par les collerettes. Ces caractéristiques optionnelles permettent d'assurer que la présence de gaz résiduel dans l'enceinte ZDU dans l'environnement immédiat du détecteur soit minimale.

De manière préférentielle, selon un mode de réalisation de l'invention, la source de génération SN est adaptée pour que ledit angle d'incidence $\theta_{inc}$ puisse être varié. La variation de l'angle d'incidence $\theta_{inc}$ implique une même variation de l'angle de réflexion $\theta_{ref}$. Afin de transporter le faisceau diffracté sans perte d'information spatiale, le dispositif comprend également un étage de translation et/ou de rotation (non représenté en figure 4) de l'ensemble de tubes de manière à ajuster la position des ouvertures en fonction de l'angle d'incidence.

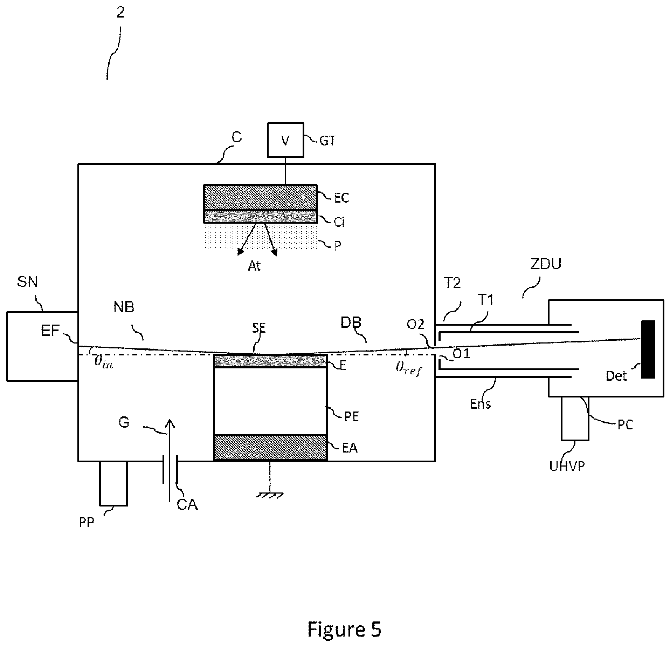

La figure 5 illustre un système 2 pour dépôt par plasma magnétron comprenant un dispositif selon l'invention pour caractériser la surface SE de l'échantillon E par la technique GIFAD au cours de son dépôt. Par comparaison au dispositif de l'invention illustré en figure 3, le système 2 comprend en outre un canal CA d'arrivée du gaz G à partir duquel sera généré le plasma P, par exemple de l'argon. Le système comprend aussi deux électrodes entre lesquelles est appliquée une tension à l'aide d'un générateur de tension GT : une cathode magnétron EC et une anode EA (ici illustrée comme connectée à la masse). La tension entre l'anode EA et la cathode EC permet une cascade d'ionisation par impact du gaz et la génération du plasma P. C'est à cause de l'intensité des champs électromagnétiques présent dans la chambre lors du dépôt que le RHEED est inutilisable pour le suivi *in situ* de cette technique. L'utilisation d'un piège magnétique de type magnétron, par exemple, couplé à la cathode EC permet de confiner les électrons dans le plasma P à proximité de la surface de la cible Ci afin d'accroitre la densité du plasma, mais aussi de permettre son fonctionnement en deça de $10^{-2}$ mbar, parfaitement compatible avec le dispositif décrit dans l'invention. Les ions du gaz G sont alors accélérés vers la cathode puis impactent la surface de la cible Ci en éjectant des atomes At de la cible avec suffisament d'énergie cinétique pour qu'ils atteignent la surface de l'échantillon, formant alors la couche SE.

A cause de la présence du gaz G et du plasma, la pression dans la chambre C est typiquement entre $10^{-3}$ *mbar* et $10^{-2}$ *mbar* en cours de déposition par plasma magnétron. Grâce au pompage différentiel du dispositif de l'invention, il est possible de mettre en œuvre la technique GIFAD lors d'une déposition par plasma magnétron.

## Revendications

1. Dispositif (1) pour la caractérisation d'une surface (SE) d'un échantillon (E) comportant :

   - une chambre (C) comprenant un support (PE) pour ledit échantillon, ladite chambre étant reliée à une pompe dite primaire (PP) adaptée pour maintenir une pression inférieure à $10^{-2}$ *mbar* au sein de ladite chambre ;
   - une source (SN) de génération d'un faisceau incident (NB) d'atomes ou molécules neutres ayant une énergie comprise entre 50 eV et 5 keV, avec une divergence inférieure ou égale à 0,05°, ladite source étant agencée pour diriger ledit faisceau incident (NB) au sein de ladite chambre par une entrée (EF) et vers ladite surface (SE) à caractériser avec un angle d'incidence ($\theta_{in}$) inférieur ou égal à 10° par rapport au plan de ladite surface, les atomes ou molécules neutres dudit faisceau incident (NB), diffusés vers l'avant par ladite surface (SE) formant un faisceau diffracté (DB) ; et

   **caractérisé en ce qu'**il comprend une enceinte de détection (ZDU) reliée à ladite chambre et reliée à une pompe dite UHVP comprenant :

   - un ensemble de tubes concentriques (Ens) chaque tube (T1, T2) présentant une extrémité dite d'entrée avec une ouverture (O1, O2), ledit ensemble comprenant un tube de plus petit rayon (T1), de longueur L ;
   - un détecteur (Det) sensible en position et adapté pour détecter une figure de diffraction (FD) des atomes ou molécules neutres dudit faisceau diffracté ;

   ladite longueur L et lesdites ouvertures (O1, O2) étant adaptées pour transporter ledit faisceau diffracté jusqu'au détecteur sans perdre d'information sur ladite surface (SE), lesdites ouvertures et ladite pompe UHVP étant adaptées pour maintenir une pression inférieure à $10^{-5}$ *mbar* au sein de l'enceinte de détection.

2. Dispositif selon la revendication précédente, dans lequel ladite ouverture de chaque tube presente un diamètre différent des autres et décroissant en fonction d'un rayon des tubes.

3. Dispositif selon l'une quelconque des revendications 1 à 2, dans lequel une ouverture (O2) de plus petit diamètre présente un diamètre inférieur ou égal à 5 mm.

4. Dispositif selon l'une quelconques des revendications précédentes, dans lequel une distance dite haute pression ($L_{HP}$) entre ladite entrée et une extrémité d'entrée des tubes est inférieure à une longueur de décohérence du faisceau incident et du faisceau diffracté.

5. Dispositif selon la revendication précédente, dans lequel ladite distance haute pression est inférieure à 10cm.

6. Dispositif selon l'une quelconque des revendications précédentes, dans lequel chaque tube présente une extrémité dite de sortie avec une collerette (Col) s'étendant dans une direction essentiellement perpendiculaire aux tubes de manière à guider un flux gazeux dans cette direction en sortie de chaque tube, un port de couplage (PC) de ladite pompe UHVP étant disposé dans ladite enceinte de détection en regard d'un espace (SP) formé par lesdites collerettes.

7. Dispositif selon l'une quelconque des revendications précédentes, dans lequel ledit détecteur comprend une galette de microcanaux, couplée à un écran fluorescent observé par une caméra.

8. Dispositif selon l'une quelconque des revendications précédentes, dans lequel ladite source de génération (SN) est adaptée pour que ledit angle d'incidence puisse être varié, ledit dispositif comprenant également un étage de translation et/ou de rotation dudit ensemble de tubes de manière à ajuster une position desdites ouvertures en fonction dudit angle d'incidence.

9. Système pour dépôt par plasma magnétron comprenant un dispositif selon l'un des revendications précédentes, agencé pour caractériser ladite surface de l'échantillon en cours de dépôt.

**Patentansprüche**

1. Vorrichtung (1) zur Charakterisierung einer Oberfläche (SE) einer Probe (E), aufweisend:

   - eine Kammer (C), die eine Halterung (PE) für die Probe umfasst, wobei die Kammer mit einer so genannten Primärpumpe (PP) verbunden ist, die dazu ausgelegt ist, einen Druck von weniger als $10^{-2}$ *mbar* in der Kammer aufrechtzuerhalten;
   - eine Quelle (SN) zur Erzeugung eines einfallenden Strahls (NB) neutraler Atome oder Moleküle mit einer Energie zwischen 50 eV und 5 keV, mit einer Divergenz kleiner oder gleich 0,05°, wobei die Quelle dazu angeordnet ist, den in der Kammer einfallenden Strahl (NB) durch einen Eingang (EF) und zu der zu charakterisierenden Oberfläche (SE) mit einem Einfallswinkel ($\theta_{in}$) kleiner oder gleich 10° bezogen auf die Ebene der Oberfläche zu richten, wobei die neutralen Atome oder Moleküle des einfallenden Strahls (NB), die von der Oberfläche (SE) nach vorn gestreut werden, einen gebeugten Strahl (DB) bilden; und

   **dadurch gekennzeichnet, dass** sie ein Detektionsgehäuse (ZDU) umfasst, das mit der genannten Kammer verbunden ist und mit einer so genannten UHVP-Pumpe verbunden ist, umfassend:

   - eine Anordnung konzentrischer Rohre (Ens), wobei jedes Rohr (T1, T2) ein so genanntes Eingangsende mit einer Öffnung (O1, O2) aufweist, wobei die Anordnung ein Rohr mit kleinerem Radius (T1) der Länge L umfasst;
   - einen positionsempfindlichen Detektor (Det), der zur Detektion eines Beugungsmusters (FD) der neutralen Atome oder Moleküle des gebeugten Strahls ausgelegt ist;

   wobei die Länge L und die Öffnungen (O1, O2) dazu ausgelegt sind, den gebeugten Strahl zu dem Detektor zu transportieren, ohne Informationen über die Oberfläche (SE) zu verlieren, wobei die Öffnungen und die UHVP-Pumpe dazu ausgelegt sind, einen Druck von weniger als $10^{-5}$ *mbar* im Detektionsgehäuse aufrechtzuerhalten.

2. Vorrichtung nach dem vorstehenden Anspruch, wobei die Öffnung jedes Rohrs einen von den anderen verschiedenen und in Abhängigkeit von einem Radius der Rohre abnehmenden Durchmesser aufweist.

3. Vorrichtung nach einem der Ansprüche 1 bis 2, wobei eine Öffnung (O2) mit kleinerem Durchmesser einen Durchmesser von kleiner oder gleich 5 mm aufweist.

4. Vorrichtung nach einem der vorstehenden Ansprüche, wobei ein so genannter Hochdruckabstand ($L_{HP}$) zwischen dem Eingang und einem Eingangsende der Rohre kleiner ist als eine Dekohärenzlänge des einfallenden Strahls und des gebeugten Strahls.

5. Vorrichtung nach dem vorstehenden Anspruch, wobei der genannte Hochdruckabstand kleiner als 10 cm ist.

6. Vorrichtung nach einem der vorstehenden Ansprüche, wobei jedes Rohr ein so genanntes Ausgangsende mit einem Kragen (Col) aufweist, der sich in einer Richtung erstreckt, die im Wesentlichen senkrecht zu den Rohren verläuft, um einen Gasstrom in dieser Richtung am Ausgang jedes Rohrs zu führen, wobei ein Kopplungsanschluss (PC) der UHVP-Pumpe in dem Detektionsgehäuse gegenüber einem Raum (SP) angeordnet ist, der von den Kragen gebildet wird.

7. Vorrichtung nach einem der vorstehenden Ansprüche, wobei der Detektor eine Mikrokanalplatte umfasst, die mit einem von einer Kamera beobachteten Fluoreszenzschirm gekoppelt ist.

8. Vorrichtung nach einem der vorstehenden Ansprüche, wobei die Erzeugungsquelle (SN) dafür ausgelegt ist, dass der Einfallswinkel variiert werden kann, wobei die Vorrichtung auch eine Translations- und/oder Rotationsstufe der Röhrenanordnung umfasst, um eine Position der Öffnungen in Abhängigkeit von dem Einfallswinkel einzustellen.

9. System für Magnetron-Plasma-Abscheidung, umfassend eine Vorrichtung nach einem der vorstehenden Ansprüche, die dazu angeordnet ist, die Oberfläche der Probe während der Abscheidung zu charakterisieren.

**Claims**

1. Device (1) for characterizing a surface (SE) of a sample (E) comprising:

   - a chamber (C) comprising a support (PE) for said sample, said chamber being connected to a primary pump (PP) adapted to maintain a pressure below $10^{-2}$ *mbar* within said chamber;
   - a source (SN) for generating an incident beam (NB) of neutral atoms or molecules having an energy between 50 eV and 5 keV, with a divergence less than or equal to 0.05°, said source being arranged to direct said incident beam (NB) within said chamber through an inlet (EF) and toward said surface (SE) to be characterized with an angle of incidence ($\theta_{in}$) less than or equal to 10° relative to the plane of said surface, the neutral atoms or molecules of said incident beam (NB), diffused forward by said surface (SE) forming a diffracted beam (DB); and

   **characterized in that** it comprises a detection enclosure (ZDU) connected to said chamber and connected to a UHVP pump comprising:

   - a set of concentric tubes (Ens) each tube (T1, T2) having an end referred to as an inlet end with an opening (O1, O2), said set comprising a tube of smallest radius (T1), of length L;
   - a detector (Det) sensitive in position and adapted to detect a diffraction pattern (FD) of the neutral atoms or molecules of said diffracted beam;

   said length L and said openings (O1, O2) being adapted to transport said diffracted beam to the detector without losing information about said surface (SE), said openings and said UHVP pump being adapted to maintain a pressure below $10^{-5}$ *mbar* within the detection enclosure.

2. Device according to claim 1, wherein the opening of each tube has a different diameter from the others and decreasing as a function of a radius of the tubes.

3. Device according to any one of claims 1 to 2, wherein an opening (O2) of smallest diameter has a diameter less than or equal to 5 mm.

4. Device according to any one of the preceding claims, wherein a distance referred to as high pressure distance ($L_{HP}$) between said inlet and an inlet end of the tubes is less than a decoherence length of the incident beam and of the diffracted beam.

5. Device according to the preceding claim, wherein said high pressure distance is less than 10 cm.

6. Device according to any one of the preceding claims, wherein each tube has an end referred to as outlet end with a flange (Col) extending in a direction substantially perpendicular to the tubes so as to guide a gas flow in this direction at the outlet of each tube, a coupling port (PC) of said UHVP pump being disposed in said detection enclosure facing a space (SP) formed by said flanges.

7. Device according to any one of the preceding claims, wherein said detector comprises a microchannel plate, coupled to a fluorescent screen observed by a camera.

8. Device according to any one of the preceding claims, wherein said generation source (SN) is adapted so that said angle of incidence can be varied, said device also comprising a translation and/or rotation stage of said set of tubes so as to adjust a position of said openings as a function of said angle of incidence.

9. System for magnetron plasma deposition comprising a device according to one of the preceding claims, arranged to characterize said surface of the sample during deposition.

Figure 1

Figure 2

Figure 3

Figure 4

Figure 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2903494

- FR 2903494 A